# EUROPEAN PATENT APPLICATION

(11) **EP 1 860 467 A1**
(43) Date of publication of application: **28.11.2007**
(21) Application number: 06290844.7
(22) Date of filing: 24.05.2006
(51) Int. Cl.: G02B 3/04, G02B 3/08, G02B 27/09, H01L 33/00, F21V 5/04

(54) **Lens and light emitting diode using the lens to achieve homogeneous illumination**

(71) Applicant: INDUSTRIAL TECHNOLOGY RESEARCH INSTITUTE, Chutung, Hsinchu (TW)
(72) Inventor: Huang, Tien-Fu, Taiwan (CN); Su, Chei-Wei, Taiwan (CN); Hu, Kuo-Chang, Taiwan (CN)
(74) Representative: Loisel, Bertrand

(57) **Abstract**

A lens (23) and an LED using the lens to achieve homogeneous illumination include a region. The region around the optical axis of a lens is designed to be concave and form a divergent surface (25). The upper surface of the lens is a continuous curved surface (26) to diverge the high-intensity light emitted by the LED in the vicinity of the optical axis (24) through refractions. Therefore, the LED can homogeneously illuminate a larger area.

## Description

### BACKGROUND OF THE INVENTION

### Field of Invention

The invention relates to a lens and a light-emitting diode (LED) using the lens for illumination systems and, in particular, to an LED with homogeneous illumination.

### Related Art

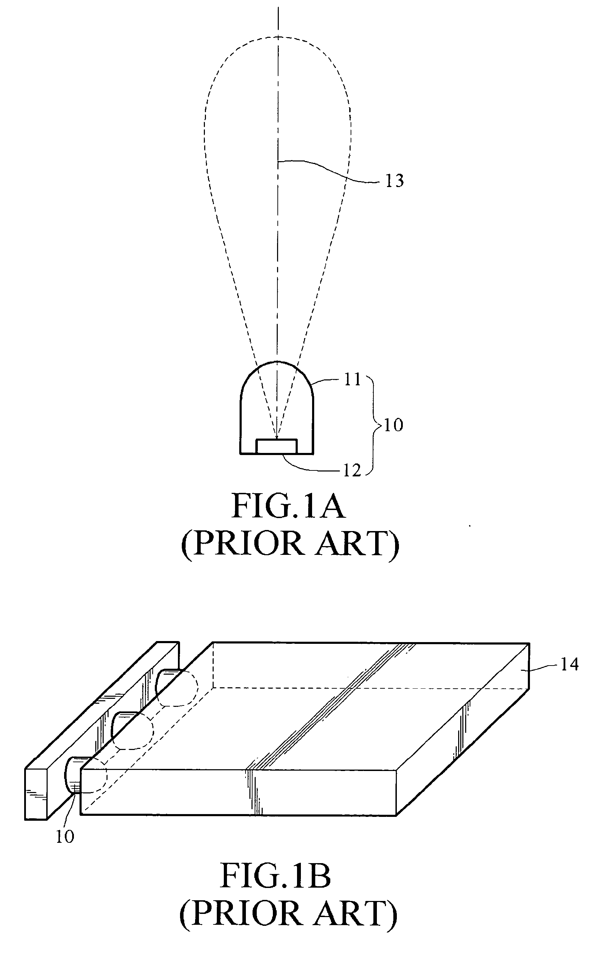

A traditional LED 10 is shown in FIG. 1A. It is formed by packing an LED chip 12 in a lens 11. The most commonly seen embodiment of the lens is illustrated in the drawing. The lens 11 is a hemisphere to converge the light emitted by the LED chip 12. The radiation pattern (directions and energy distribution of the emitted light) has to be restricted in the vicinity of the optical axis 13. Since the energy is more concentrated, one has to rely on the use of a light-guiding plate 14 to improve the homogeneity in the case of a surface plane light source. However, if the LED's 10 are directly distributed under the light-guiding plate, it requires a fair amount of LED's 10 because each one of them has a very small illuminating area. Therefore, one usually adopts the side-illuminating structure to achieve the required homogeneity of a surface plane light source, as shown in FIG. 1B. However, since the LED's 10 can provide the optical energy only at the edge of the light-guiding plate 14, the distance between the central part and the adjacent light sources becomes larger when the area of the surface plane light source is big. Therefore, the optical energy transmitted to the central part by virtue of total reflections become insufficient as the area enlarges. In other words, there is a certain limit for the area of the surface plane light source.

To overcome this problem, U.S. Pat. No. 6,679,621 uses a special lens shape to totally reflect the light coming out of the top surface of the LED and to deflect the light coming out of its side surfaces. All beams are emitted in parallel but orthogonal to the optical axis. Therefore, in the construction of a planar light surface, the LED's can be disposed in the middle of the light-guiding plate, instead of being limited to its edges. As the area of the surface plane light source gets larger, there will not be any problem of insufficient optical energy on the light-guiding plate due to the far distances to the light source. Nevertheless, the design relies on the total reflection and refraction of light. The overall light-emitting efficiency is lowered due to the attenuation of multiple reflections and refractions inside the light source system.

### SUMMARY OF THE INVENTION

In view of the foregoing, an object of the invention is to provide a lens and a homogeneously illuminating LED using the lens. The invention can provide a large-area, homogeneous light-emitting surface. It can be directly used in a surface plane light source system. It further reduces the use of LED's to save the cost.

To achieve the above object, the disclosed lens and the LED that uses the lens have a lens designed on an action surface and in such a way that a concave divergent surface is formed around the optical axis. This design can deflect the light emitted in the vicinity of the optical axis away from the optical axis, so that the LED can provide a homogeneous and large-area light-emitting surface. According to a first embodiment, the invention includes a substrate, an LED chip, and a lens. The lens is bonded onto the substrate by packaging and covers the LED chip. The lens has a divergent surface around the optical axis and an adjacent convergent surface. The divergent surface diverges the light around the optical axis, and the convergent surface converges light of large angles toward the optical axis. Thus, the LED's can provide more homogeneous light in a larger area.

In a second embodiment of the invention, the lens is designed to have a concave part at its bottom and to be directly connected to the substrate. The concave part covers the LED chip.

In a third embodiment of the invention, the concave part at the bottom of the lens is designed to be the top surface of a conventional LED. The lens is directly installed on the conventional LED.

In a fourth embodiment, the lens is in the form of a Fresnel lens. Its equivalent lens is the same as before. However, the thickness of it is reduced to have more practical applications.

### BRIEF DESCRIPTION OF THE DRAWINGS

The invention will become more fully understood from the detailed description given hereinbelow illustration only, and thus are not limitative of the present invention, and wherein:
FIG. 1A is a schematic view of a conventional LED and its light-emitting style.
FIG. 1B is a schematic view of a conventional backlit module.
FIG. 2 is a schematic view of the disclosed LED according to the first embodiment of the invention.
FIG. 3 is a light intensity distribution diagram of the disclosed LED.
FIG. 4 compares the light-emitting area of the disclosed LED.
FIG. 5 is a schematic view of the disclosed LED according to the second embodiment of the invention.
FIG. 6 is a schematic view of the disclosed LED according to the third embodiment of the invention.
FIG. 7 is a schematic view of the disclosed LED according to the fourth embodiment of the invention.
FIG. 8 shows an application of the invention.
FIGS. 9A and 9B to 12A and 12B give the experimental data in our simulations.

### DETAILED DESCRIPTION OF THE INVENTION

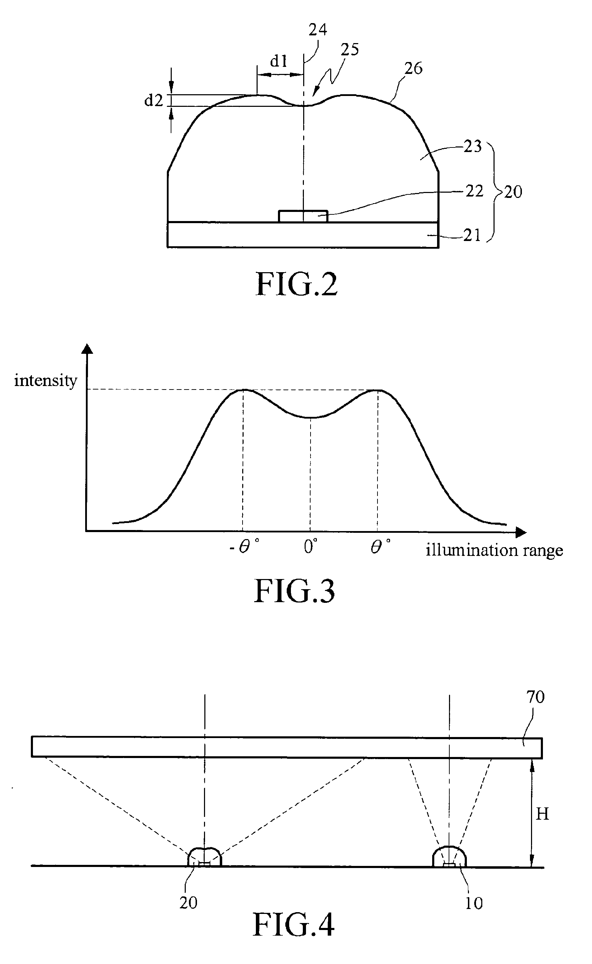

In observation of the fact that the conventional LED usually has stronger light intensity around its optical axis, the disclosed lens and the LED using the disclosed lens diverge light in the vicinity of the optical axis. The first embodiment of the invention is shown in FIGS. 2 and 3. It contains a substrate 21, an LED chip 22, and a lens 23. The LED chip 22 is installed on the substrate 21. The lens 23 is connected to the substrate 21 by packaging to cover the LED chip 22. On the surface of the lens 23 and in the vicinity of the optical axis 24 is formed with a concave part as a divergent surface 25. Beyond the divergent surface 25 is a convergent surface 26. The thickness of the divergent surface 25 increases from the optical axis outwards. The thickness of the convergent surface 26 decreases from the maximum outward. The upper action surface of the lens 23 is a continuous curved surface. The action surface referred herein means the surface above the lens 23 for the light emitted by the LED chip 22 to deflect. With this action surface, one is able to obtain a large-area and homogeneous beam of light. Therefore, the action surface does not necessarily mean the whole upper surface of the lens 23. It can be only a part of the upper surface. The size of the action surface is determined by the width and height of the lens 23, and type of the LED chip 22. The light emitted by the LED chip 22 and going through the divergent surface 25 is deflected away from the optical axis 24, whereas the light emitted by the LED chip 22 and going through the convergent surface 26 is deflected toward the optical axis 24. Therefore, the light intensity within a certain range becomes more homogeneous. The light intensity distribution is shown in FIG. 3. As one can see, the maximum intensity region is shifted outward away from the optical axis 24. The overall light-emitting region is larger and more homogeneous. In particular, the distance to the maximum light intensity region can be adjusted according to the distance d1 from the highest point on the surface of the lens 23 to the optical axis 24 and the height difference d2 from the lowest point of the divergent surface 25 to the highest point. A common design is that the lens 23 is a cylinder symmetric about the optical axis 24. Therefore, the intersection between the divergent surface 25 and the optical axis 24 is the lowest point. The distance d1 and the height difference d2 can be adjusted according to the refractive index, temperature coefficient, thickness, and height of the lens, the LED chip, and the desired homogeneous light-emitting area.

Since the divergent surface 25 is used to diverge the light near the optical axis 24, it is preferably to use a concave surface. However, it can be a mixture of concave and convex surfaces. The convergent surface 26 is used to converge light with large emission angles. Therefore, it is preferably to be a convex surface. As shown in FIG. 4, when projecting light on a screen 70 at a distance of H, the disclosed LED 20 has a larger and more homogeneous light-emitting range, in comparison with the conventional LED 10.

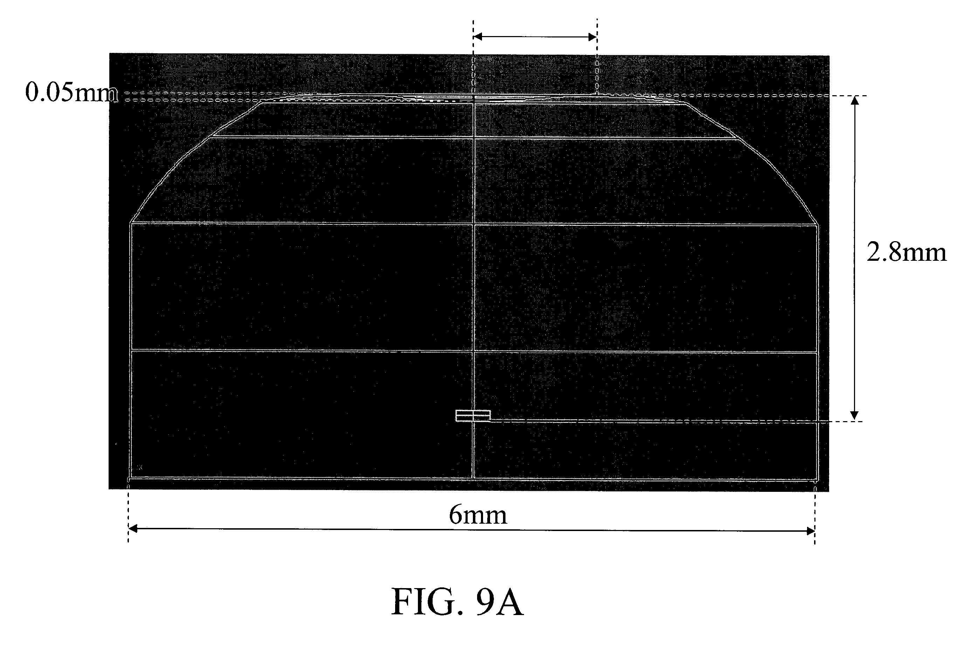

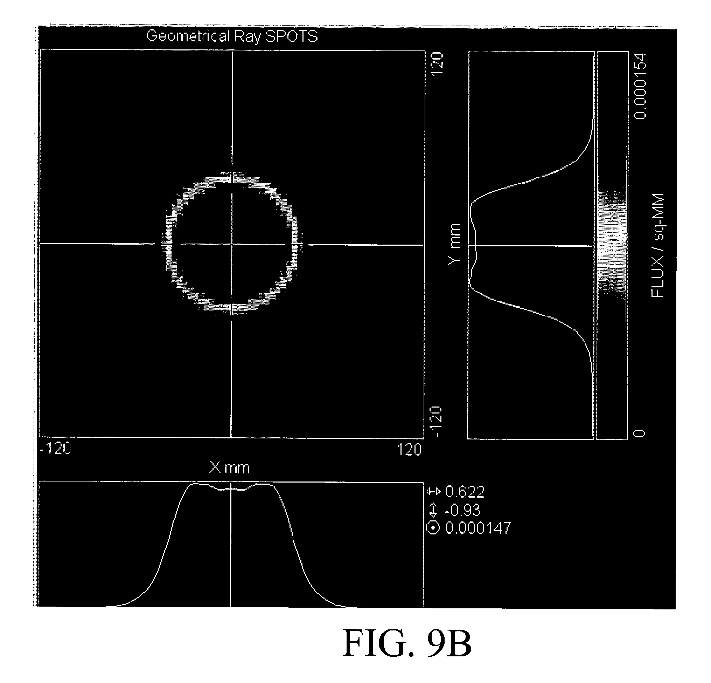

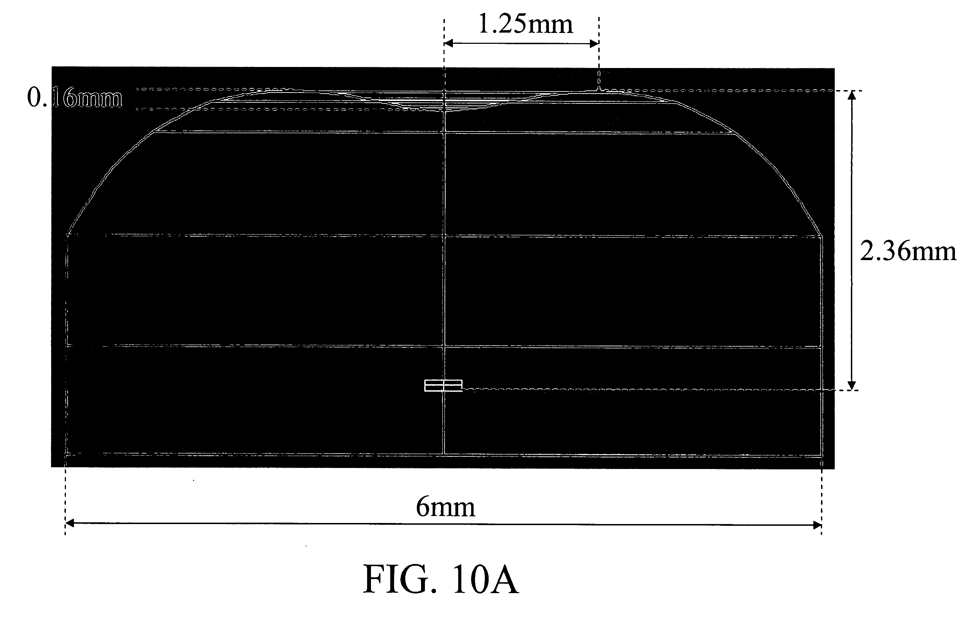

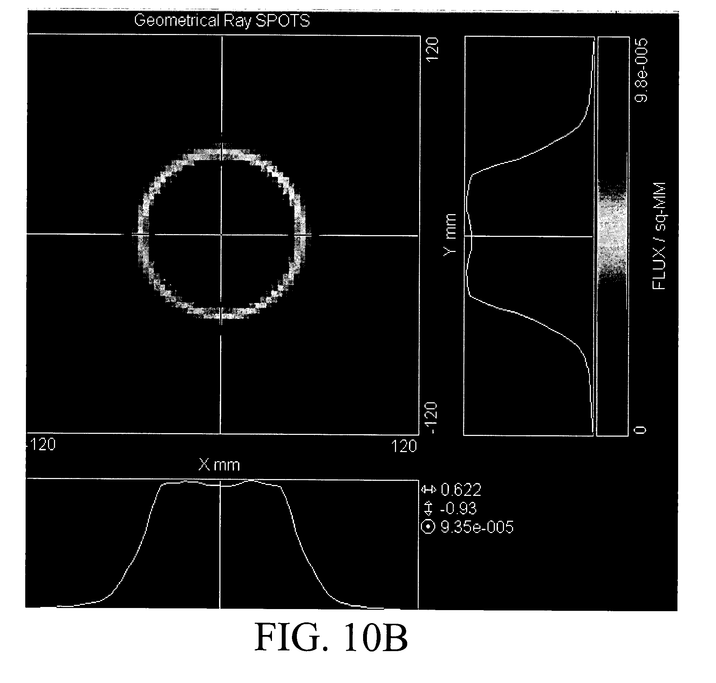

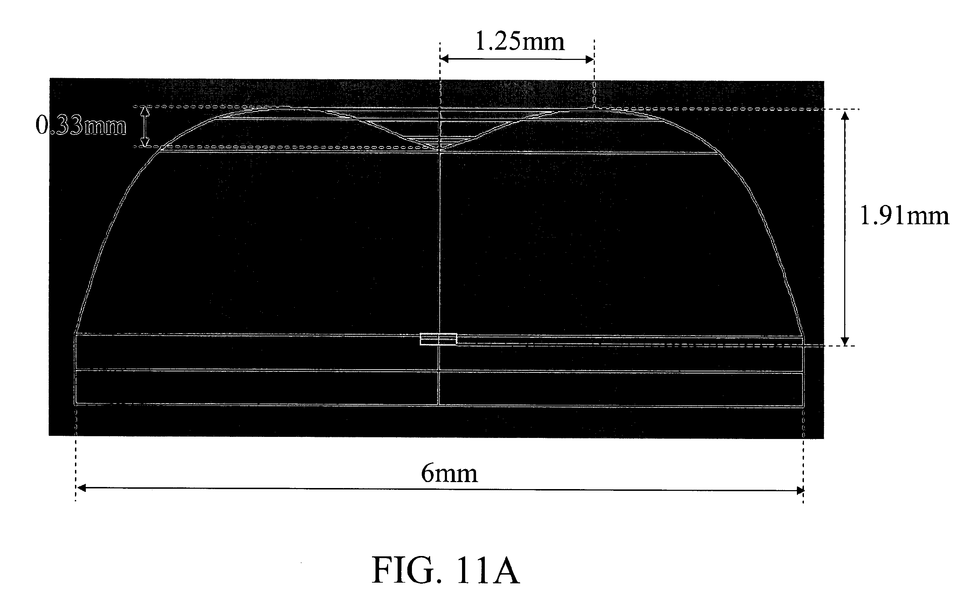

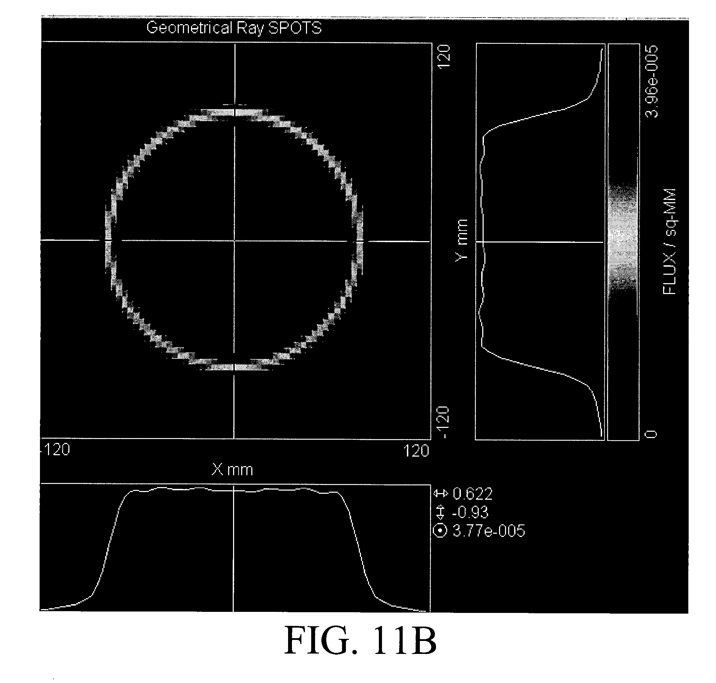

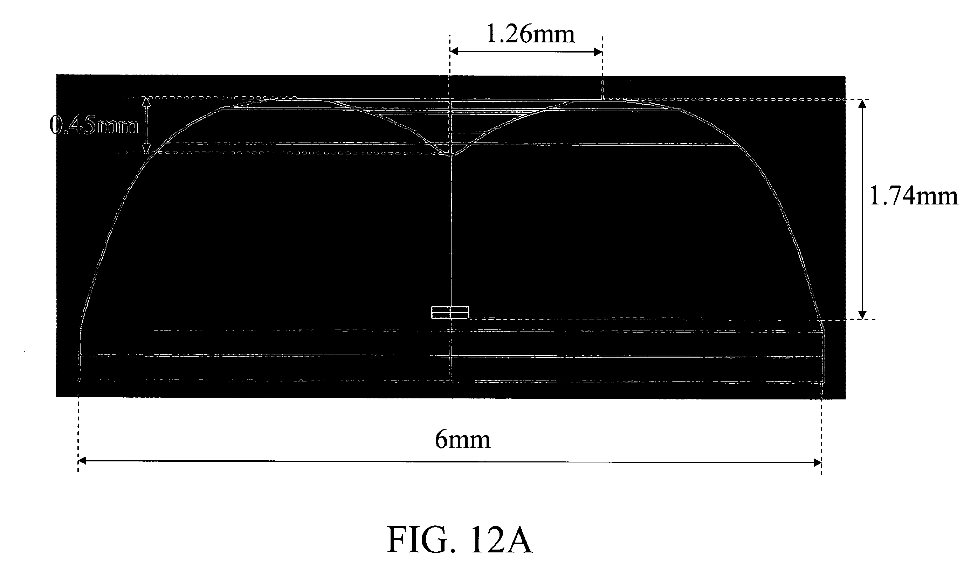

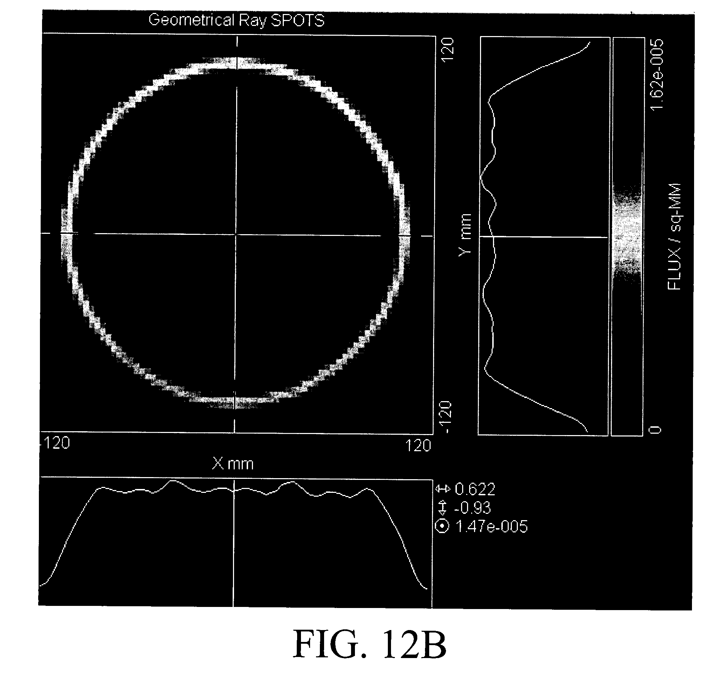

With reference to FIGS. 9A and 9B, one sees that the homogeneous light-emitting area is about 33 mm from the optical axis according to the first experimental data set. The LED chip has a distance of 30 mm. Therefore, we obtain a subtending angle of 47.7 degrees. Likewise, the subtending angle in FIGS. 10A and 10B is 53.8 degrees, that in FIGS. 11A and 11B is 67.4 degrees, and that in FIGS. 12A and 12B is 72.3 degrees. We therefore see that the subtending angle is enlarged to 45 to 75 degrees using the invention.

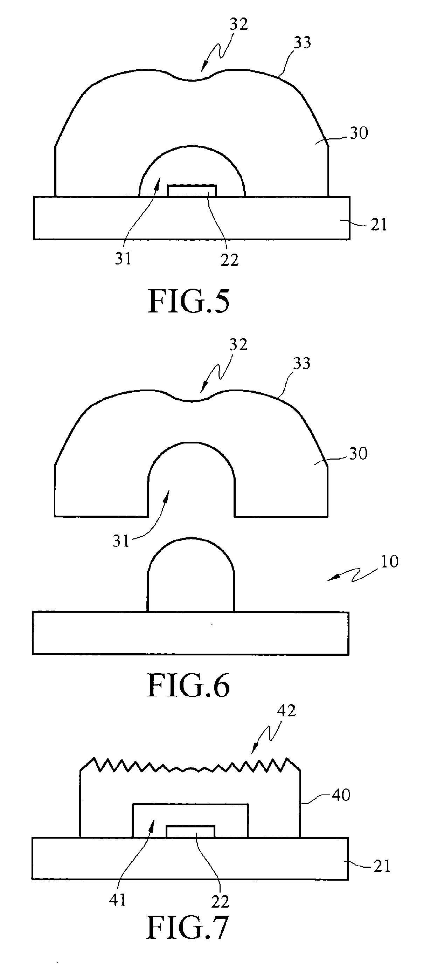

On the other hand, the second embodiment of the invention is shown in FIG. 5. The lens 30 is designed to be a mask. Its surface also has a divergent surface 32 and a convergent surface 33. Its bottom has a concave part 31 that is greater than the LED chip 22. When the lens 30 is connected to the substrate 21, the concave part 31 covers the LED chip 22. A large-area homogeneous light-emitting area is also obtained.

A third embodiment of the invention is shown in FIG. 6. The concave part 31 is designed according to the shape of the LED 10 so that it can be directly combined with a conventional LED 10. This design is more convenient in use. However, the light-emitting efficiency is slightly lower due to the extra deflection.

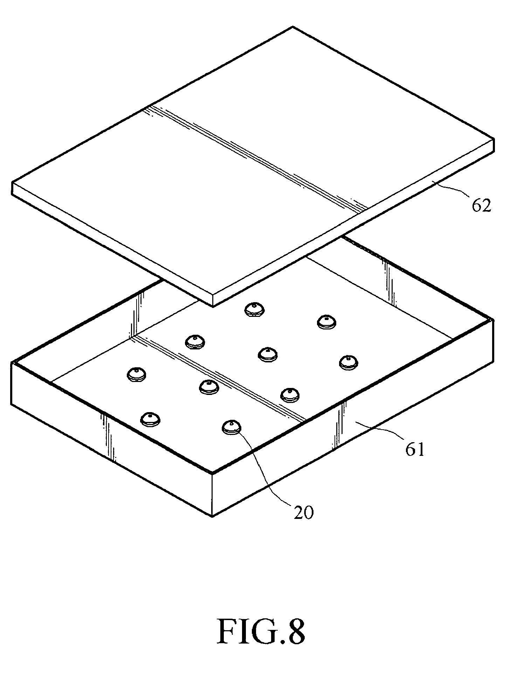

A fourth embodiment is shown in FIG. 7. The surface of the lens 40 has the form of a Fresnel lens 42. The bottom also has a concave part 41 for accommodating an LED chip 22. The equivalent lens of the Fresnel lens-like surface 42 is the same as the above-mentioned lens 23 (see FIG. 2). This design can reduce the thickness of the LED and allow wider applications.

As shown in FIG. 8, pluralities of LED's 20 are distributed on the frame 61 of a backlit module. A diffusive plate 62 is combined from the top. This can be used in a backlit module because the LED's 20 have better homogeneity and light-emitting range. In comparison with the prior art, the required number of LED's 20 for a backlit module of the same thickness can be reduced. In this case, it is less likely to have focused light spots.

Certain variations would be apparent to those skilled in the art, which variations are considered within the spirit and scope of the claimed invention.

## Claims

1. A lens having a circularly symmetric structure and a continuous action surface with a concave part in the middle of its surface, defined as a divergent surface, and a convergent surface around the divergent surface, wherein the thickness of the divergent surface increases outwards whereas the thickness of the convergent surface decreases outwards.

2. The lens of claim 1, wherein the divergent surface is a combination of curved surfaces and anti-curved surfaces.

3. The lens of claim 1, wherein the convergent surface is a convex surface.

4. A light-emitting diode (LED) that emits homogeneous light, comprising:
an LED chip, which has an optical axis; and
a lens, which has a circularly symmetric structure and covers the LED chip and whose action surface is a continuous curved surface, wherein the action surface in the vicinity of the optical axis has a concave part, defined as a divergent surface, and the divergent surface is surrounded by a convergent surface, the thickness of the divergent surface increases outwards and the thickness of the convergent surface decreases outwards, so that the light emitted from the LED chip is deflected away from the optical axis as it goes through the divergent surface and is deflected toward the optical axis as it goes through the convergent surface.

5. The LED of claim 4, wherein the subtending angle of the homogeneous light-emitting range of the LED chip is between 45 degrees and 75 degrees.

6. The LED of claim 4, wherein the lowest point on the divergent surface is at the intersection of the optical axis and the divergent surface.

7. The LED of claim 4, wherein the divergent surface is a combination of curved and anti-curved surfaces.

8. The LED of claim 4, wherein the convergent surface is a convex surface.

9. A light-emitting diode (LED) that emits homogeneous light, comprising:
a substrate;
an LED chip, which is installed on the substrate and has an optical axis; and
a lens, whose bottom has a concave part to cover the LED chip when the lens is connected to the substrate and whose action surface is a continuous curved surface, wherein the action surface in the vicinity of the optical axis has a concave part, defined as a divergent surface, and the divergent surface is surrounded by a convergent surface, the thickness of the divergent surface increases outwards and the thickness of the convergent surface decreases outwards, so that the light emitted from the LED chip is deflected away from the optical axis as it goes through the divergent surface and is deflected toward the optical axis as it goes through the convergent surface.

10. The LED of claim 9, wherein the subtending angle of the homogeneous light-emitting range of the LED chip is between 45 degrees and 75 degrees.

11. The LED of claim 9, wherein the lowest point on the divergent surface is at the intersection of the optical axis and the divergent surface.

12. The LED of claim 9, wherein the divergent surface is a combination of curved and anti-curved surfaces.

13. The LED of claim 9, wherein the convergent surface is a convex surface.

14. A light-emitting diode (LED) that emits homogeneous light, comprising:
an LED module, which has an optical axis; and
a lens, whose bottom has a concave part to combine with the top part of the LED module and whose action surface is a continuous curved surface,
wherein the action surface in the vicinity of the optical axis has a concave part, defined as a divergent surface, and the divergent surface is surrounded by a convergent surface, the thickness of the divergent surface increases outwards and the thickness of the convergent surface decreases outwards, so that the light emitted from the LED chip is deflected away from the optical axis as it goes through the divergent surface and is deflected toward the optical axis as it goes through the convergent surface.

15. The LED of claim 14, wherein the subtending angle of the homogeneous light-emitting range of the LED chip is between 45 degrees and 75 degrees.

16. The LED of claim 14, wherein the lowest point on the divergent surface is at the intersection of the optical axis and the divergent surface.

17. The LED of claim 14, wherein the divergent surface is a combination of curved and anti-curved surfaces.

18. The LED of claim 14, wherein the convergent surface is a convex surface.

19. A light-emitting diode (LED) that emits homogeneous light, comprising:
a substrate;
an LED chip, which is installed on the substrate and has an optical axis; and
a lens, which is formed on the substrate to cover the LED chip and whose surface is in the form of a Fresnel lens;
wherein the action surface of the lens in the vicinity of the optical axis has a concave part, defined as a divergent surface, and the divergent surface is surrounded by a convergent surface, the thickness of the divergent surface increases outwards and the thickness of the convergent surface decreases outwards, so that the light emitted from the LED chip is deflected away from the optical axis as it goes through the divergent surface and is deflected toward the optical axis as it goes through the convergent surface.

20. The LED of claim 19, wherein the subtending angle of the homogeneous light-emitting range of the LED chip is between 45 degrees and 75 degrees.

21. The LED of claim 19, wherein the lowest point on the divergent surface is at the intersection of the optical axis and the divergent surface.

22. The LED of claim 19, wherein the divergent surface is a combination of curved and anti-curved surfaces.

23. The LED of claim 19, wherein the convergent surface is a convex surface.
